# EUROPEAN PATENT APPLICATION

(11) **EP 1 039 519 A2**
(43) Date of publication of application: **27.09.2000**
(21) Application number: 00105346.1
(22) Date of filing: 17.03.2000
(51) Int. Cl.: H01L 21/312, H01L 21/768, H01L 23/532, H01L 21/316

(54) **Method and apparatus for forming a porous SiO2 interlayer insulating film**

(30) Priority: 26.03.1999 JP 8318099
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Maeda, Kazuo, Semiconductor Process Laboratory, Tokyo 108-0075 (JP)
(74) Representative: Schwabe - Sandmair - Marx

(57) **Abstract**

Disclosed is a method for forming an interlayer insulating film comprising the steps of forming an underlying insulating film on a substrate; forming a film containing B (boron), C (carbon) and H₂O on the underlying insulating film by plasma enhanced chemical vapor deposition using a source gas containing an Si-C-O-H compound, an oxidative gas and a compound containing B (boron); releasing C (carbon) and H₂O in the film from the film by annealing the film, and thereby forming a porous SiO₂ film containing B (boron); and subjecting to the porous SiO₂ film containing B (boron) to H (hydrogen) plasma treatment, and then forming a cover insulating film.

## Description

### BACKGROUND OF THE INVENTION

The present invention relates to a method for forming an interlayer insulating film and, more particularly, to a method for forming an interlayer insulating film having a low dielectric constant, which is necessary for a highly-integrated semiconductor device. A progress in high integration regarding the semiconductor device in recent years has resulted in a narrower interval between wiring layers. As the narrowed interval between the wiring layers causes an increase in capacitance between the wiring layers, a request has been made for formation of an interlayer insulating film, which has a low dielectric constant.

With recent progresses in high integration of an LSI device, the wiring layer has been made fine and multilayered. There has also been an increase in capacitance between the wiring layers. Such an increase in capacitance has caused a great reduction in an operating speed. Thus, improvement in this regard has been strongly demanded. As one of improvement measures, a method for reducing capacitance between the wiring layers has been studied. This method uses an interlayer insulating film, which has a dielectric constant lower than that of SiO₂ currently used for an interlayer insulating film.

Typical interlayer insulating films of low dielectric constants currently under study are ① an SiOF film, and ② an organic insulating film of a low dielectric constant. Description will now be made of these films.

### ① SiOF Film

An SiOF film is formed by using source gas containing F and substituting Si-F bond for a portion of Si-O bond in SiO₂. This SiOF film has a relative dielectric constant, which is monotonically reduced as concentration of F in the film increases.

For forming such SiOF films, several methods have been reported (see p.82 of monthly periodical "Semiconductor World", February issue of 1996). Most promising among these methods is one for forming an SiOF film by using SiH₄, O₂, Ar and SiF₄ as source gases, and by a high-density plasma enhanced CVD method (HDPCVD method). A relative dielectric constant of an SiOF film formed by this method is in a range of 3.1 to 4.0 (varies depending on F concentration in the film). This value is lower than a relative dielectric constant 4.0 of SiO₂, which has conventionally been used for the interlayer insulating film.

### ② Organic Insulating Film of Low Dielectric Constant

As an insulating film which has a lower dielectric constant (3.0 or lower) compared with the SiOF film, an organic insulating film of a low dielectric constant is now a focus of attention. Table 1 shows a few organic insulating films of low dielectric constants, which have been reported, and respective relative dielectric constants and thermal decomposition temperatures thereof.

**TABLE 1**

| Organic Insulating Film | Relative Dielectric Constant | Thermal Decomposition Temperature (°C) | Note |
|---|---|---|---|
| Fluorine-containing resin | 2.4 | 420 | p.82 of monthly periodical "Semiconductor World", February issue of 1997 |
| Cytop | 2.1 | 400 | p. 90 of monthly periodical "Semiconductor World", February issue of 1996 |
| Amorphous telon | 1.9 | 400 | p. 91 of monthly periodical "Semiconductor World", February issue of 1996 |

However, the SiOF film is disadvantageous in that an increase in concentration of F in the film leads to a reduction in moisture absorption resistance. The reduced moisture absorption resistance poses a serious problem, because a transistor characteristic and adhesion of an upper barrier metal layer are affected.

Peeling-off easily occurs in the organic insulating film of a low dielectric constant, because of bad adhesion with a silicon wafer or the SiO₂ film. Furthermore, the organic insulating film is disadvantageous in that heat resistivity is low since a thermal decomposition temperature is around 400 °C. The disadvantage of low heat resistivity poses a problem for annealing a wafer at a high temperature.

### SUMMARY OF THE INVENTION

It is an object of the present invention to provide a method for forming an interlayer insulating film having good moisture absorption resistance, good heat resistivity and a low dielectric constant, a semiconductor device using the interlayer insulating film, and a semiconductor manufacturing apparatus for forming the interlayer insulating film.

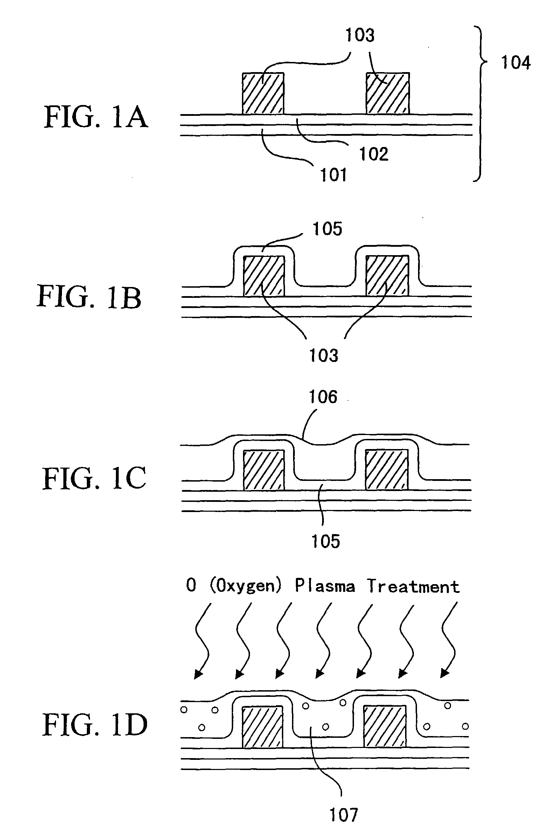

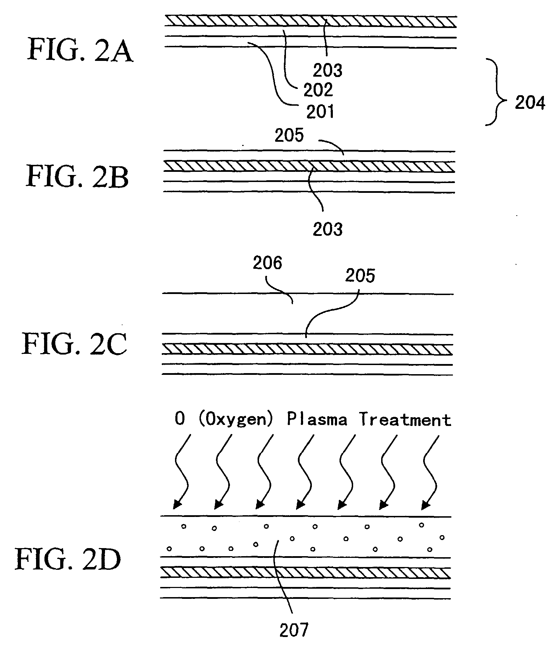

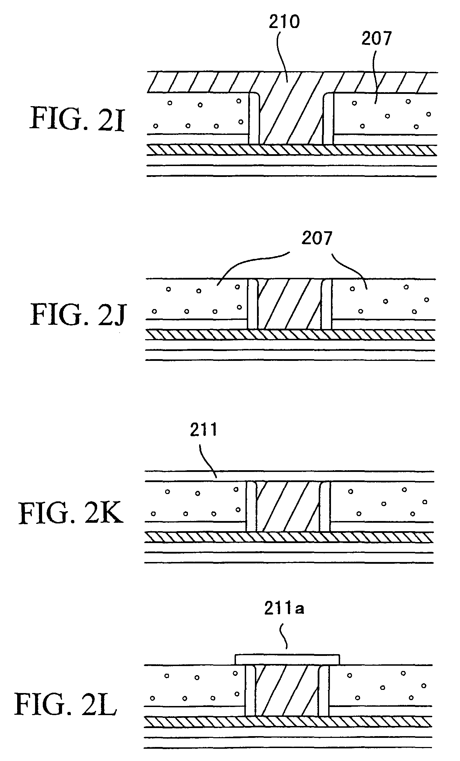

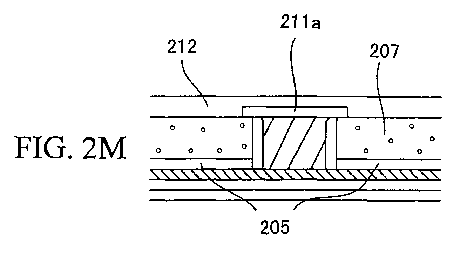

According to the method for forming the interlayer insulating film according to the present invention, as illustrated in FIG. 1C, the film is formed on an object to be formed (a substrate) by using plasma enhanced chemical vapor deposition using a source gas (or a reaction gas) containing an Si-C-O-H compound, O₂ and B₂H₆. B (boron), C (carbon) and H₂O are contained in the film thus formed. The inventor found that this film is annealed by using O (oxygen) plasma whereby C (carbon) and H₂O in the film are released from the film and thus many voids are created in the film, as illustrated in FIG. 1D. Thus, a porous SiO₂ film containing B (boron) can be formed on the substrate. When the film containing B (boron), C (carbon) and H₂O is formed on the substrate, H₂O contained in the film may enter into the substrate. This can be prevented in the following manner. That is, as illustrated in FIGS. 1B and 2B, an underlying insulating film is formed on the substrate, and then the film containing B (boron), C (carbon) and H₂O is formed.

Moreover, the inventor found that the film containing a C-O-H polymer is formed by the plasma enhanced chemical vapor deposition using the source gas containing the Si-C-O-H compound and H₂ (hydrogen) and then this film is annealed by using the O (oxygen) plasma whereby the porous SiO₂ film can be formed in the same manner as described above. In this case, the C-O-H polymer contained in the film is oxidized by the O (oxygen) plasma, thus the C-O-H polymer is released from the film, and consequently the voids are created in the film.

Furthermore, the inventor found the following fact. In forming the film containing the C-O-H polymer, O₂ is added to the source gas, whereby the larger voids are created in the film, and a content of SiO₂ in the film increases and thus the film is stabilized.

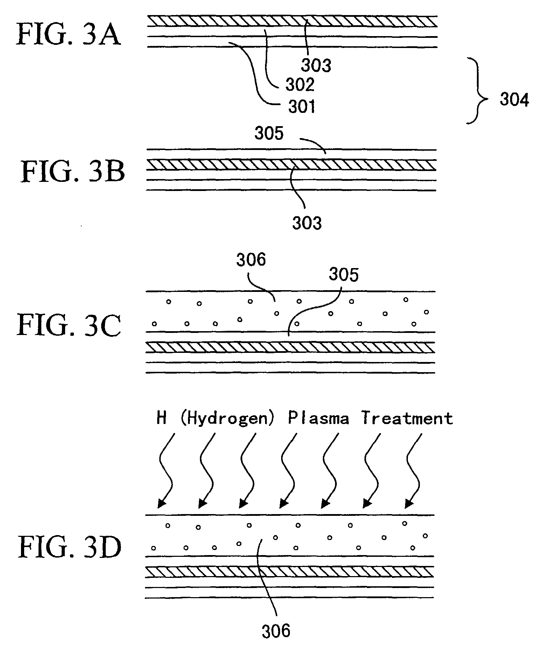

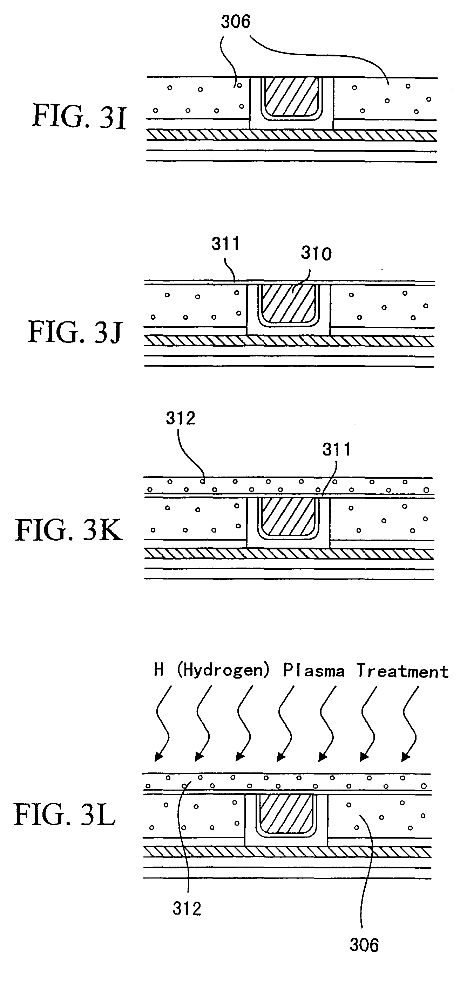

Desirably, the film containing the C-O-H polymer has such a thinness that the C-O-H polymer is sufficiently oxidized by the O (oxygen) plasma. Therefore, the inventor invented the method for forming the porous SiO₂ film having a desired thickness by alternately repeating the formation of the film containing the C-O-H polymer and the oxidization by the O (oxygen) plasma, as illustrated in FIG. 3C.

On the other hand, the porous SiO₂ film formed as described above has many voids in the film. Thus, a surface area of the porous SiO₂ film is larger than the surface area of the SiO₂ film having no void. Thus, the porous SiO₂ film is prone to absorb moisture in the air. Thus, the porous SiO₂ film is subjected to H (hydrogen) plasma treatment as illustrated in FIGS. 1E, 2E, 3D and 3L. By this treatment, a dangling bond in an Si-O bond on a surface of the voids is substituted with an Si-H bond. As a result, it is possible to prevent the moisture from being adsorbed on the surface of the voids. Furthermore, a cover insulating film is formed on the porous SiO₂ film as illustrated in FIGS. 1H and 2M, whereby it is possible to prevent the moisture from being absorbed.

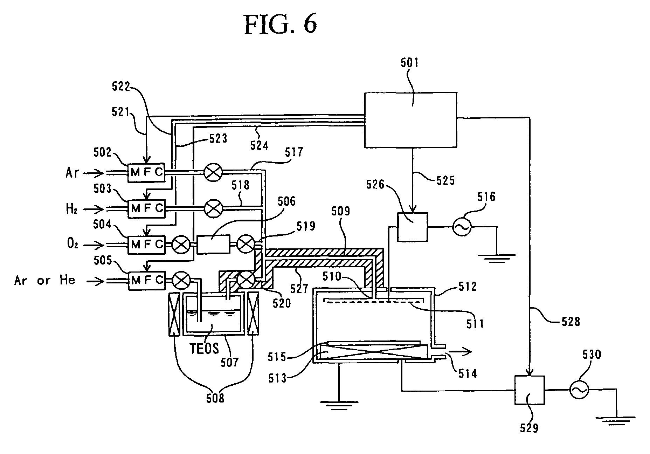

Moreover, the semiconductor manufacturing apparatus according to the present invention has control means for controlling flow rate control means for controlling a flow rate of the source gas and switching means for switching a high-frequency voltage applied to a chamber, as illustrated in FIG. 6.

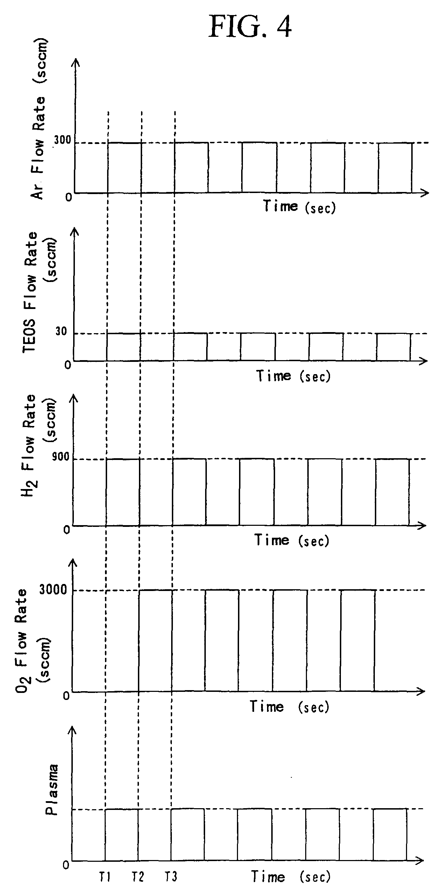

This control means allows alternately repeating the plasma enhanced chemical vapor deposition and the annealing in one chamber, as illustrated in FIG. 4. That is, during a time period from T1 to T2 in FIG. 4, the source gases (H₂, TEOS (Tetra-Ethyl-Ortho-Silicate) and Ar) are introduced into the chamber and the high-frequency voltage is applied to the chamber, whereby the plasma enhanced chemical vapor deposition takes place. During the time period from T2 to T3, O₂ is applied to the chamber which the high-frequency voltage is not applied to, whereby the annealing is performed in an atmosphere of O₂.

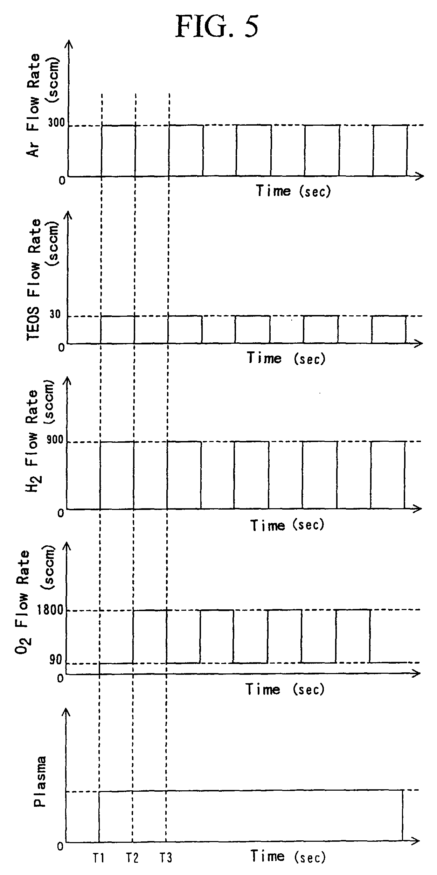

Furthermore, as illustrated in FIG. 5, this control means is used, whereby the plasma enhanced chemical vapor deposition and the annealing in a plasma atmosphere can be alternately repeated in one chamber. That is, during the time period from T1 to T2 in FIG. 5, the source gases (H₂, TEOS, O₂ and Ar) are introduced into the chamber and the high-frequency voltage is applied to the chamber, whereby the plasma enhanced chemical vapor deposition takes place. During the time period from T2 to T3, O₂ alone is introduced into the chamber which the high-frequency voltage is applied to, whereby the annealing is performed in the plasma atmosphere of O₂.

### BRIEF DESCRIPTION OF THE DRAWINGS

FIGS. 1A to 1H are cross-sectional views showing a method for forming an interlayer insulating film according to a first embodiment of the present invention;
FIGS. 2A to 2M are cross-sectional views showing the method for forming the interlayer insulating film according to a second embodiment of the present invention;
FIGS. 3A to 3L are cross-sectional views showing the method for forming the interlayer insulating film according to third and fourth embodiments of the present invention;
FIG. 4 shows characteristics of time dependency of an Ar flow rate, a TEOS flow rate, an H₂ flow rate, an O₂ flow rate and plasma in the method for forming the interlayer insulating film according to the third embodiment of the present invention and a semiconductor manufacturing apparatus according to a fifth embodiment;
FIG. 5 shows the characteristics of the time dependency of the Ar flow rate, the TEOS flow rate, the H₂ flow rate, the O₂ flow rate and the plasma in the method for forming the interlayer insulating film according to the fourth embodiment of the present invention and the semiconductor manufacturing apparatus according to the fifth embodiment; and
FIG. 6 shows a constitution of the semiconductor manufacturing apparatus according to the fifth embodiment of the present invention.

### DESCRIPTION OF THE PREFERRED EMBODIMENTS

Next, embodiments of the present invention will be described with reference to the accompanying drawings.

### (1) Description of a method for forming an interlayer insulating film according to the embodiments of the present invention

### (a) First embodiment

FIGS. 1A to 1H are cross-sectional views for describing the first embodiment.

First, as shown in FIG. 1A, a BPSG (borophosphosilicate glass) film 102 is formed on a silicon substrate 101. Then, an aluminum film is formed on the BPSG film 102 and then the aluminum film is patterned, whereby an aluminum wiring layer 103 is formed. An object 104 to be formed (or a substrate) comprises the silicon substrate 101, the BPSG film 102 and the aluminum wiring layer 103 which are formed in this manner.

Then, as shown in FIG. 1B, an SiO₂ film 105 (an underlying insulating film) is formed on the substrate 104. This SiO₂ film 105 is formed by PECVD method (plasma enhanced chemical vapor deposition). SiH₄ and N₂O are used as a source gas. A thickness of the SiO₂ film 105 is 100 nm.

Then, as shown in FIG. 1C, an SiO₂ film 106 having a thickness of 500 nm and containing B (boron) is formed on the SiO₂ film 105 (the underlying insulating film). The SiO₂ film 106 containing B (boron) is formed by CVD method (Enhanced chemical vapor deposition) under a pressure of 1 Torr by applying an RF power having a frequency of 13.56 MHz with the silicon substrate 101 kept at 100 °C in an atmosphere of TEOS (Tetra-Ethyl-Ortho-Silicate), B₂H₆, O₂ and Ar. C (carbon) and an OH group as well as B are contained in the B-(boron)-containing SiO₂ film 106 formed in this manner. In this case, a flow rate of the source gas is as follows: the flow rate of TEOS is 30 sccm, the flow rate of B₂H₆ is 30 sccm, the flow rate of O₂ is 90 sccm, and the flow rate of Ar is 900 sccm.

Then, as shown in FIG. 1D, the SiO₂ film 106 containing B (boron) is subjected to O (oxygen) plasma treatment. At this time, C (carbon) and the OH group contained in the SiO₂ film 106 containing B (boron) react with an O atom in O (oxygen) plasma. Thus, C (carbon) and the OH group are changed to CO₂ and H₂O, and then CO₂ and H₂O are released from the film. Then, voids are created in places which have contained C (carbon) and the OH group in the SiO₂ film 106 containing B (boron). Consequently, the SiO₂ film 106 containing B (boron) is changed to a porous SiO₂ film 107 containing B (boron).

Subsequently, as shown in FIG. 1E, the porous SiO₂ film 107 containing B (boron) is subjected to H (hydrogen) plasma treatment. By this treatment, a dangling bond in an Si-O bond in the film is substituted with an Si-H bond. Thus, the film improves in moisture absorption resistance.

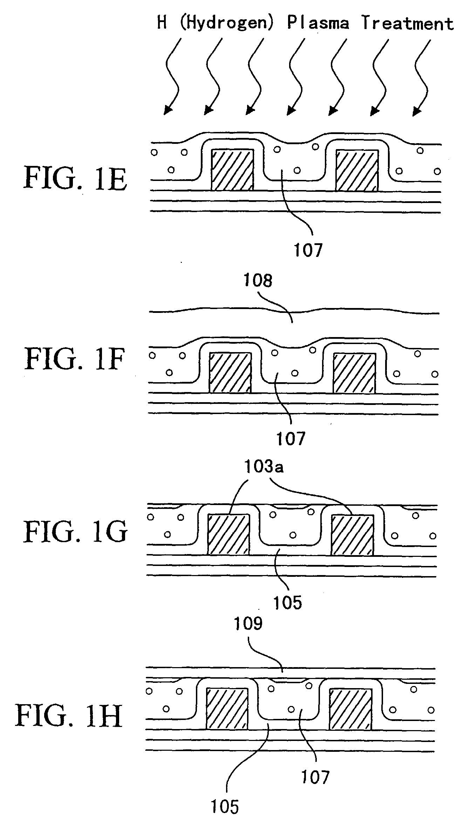

Then, as shown in FIG. 1F, an SiO₂ film 108 is formed on the porous SiO₂ film 107 containing B (boron). This SiO₂ film 108 is formed in order to planarize a surface. The SiO₂ film 108 is formed by the CVD method using TEOS and O₃ as the source gas. O₃ for use in this case has a density enough to oxidize TEOS. Thus, the SiO₂ film 108 results in a fluidic SiO₂ film.

Then, as shown in FIG. 1G, the SiO₂ film 108 is etched, whereby the surface is planarized. At this time, the SiO₂ film (the underlying insulating film) 105 and the porous SiO₂ film 107 containing B (boron), which are previously formed, are partly removed by etching. The planarising by the etching is conducted such that the SiO₂ film 105 formed on a convexity 103a of the aluminum wiring layer is not completely removed.

Then, as shown in FIG. 1H, an SiO₂ film (a cover insulating film) 109 is formed on the planarized surface. This SiO₂ film 109 is formed by the PECVD method. SiH₄ and N₂O are used as the source gas. The thickness of the SiO₂ film 109 is 100 nm.

The interlayer insulating film having good heat resistivity, good moisture absorption resistance and a low dielectric constant is formed on the substrate 104 by the SiO₂ film (the underlying insulating film) 105, the SiO₂ film 108, the SiO₂ film (the cover insulating film) 109 and the porous SiO₂ film 107 containing B (boron) which are formed as described above. That is, the SiO₂ film 107 containing B (boron) is porous, and thus the dielectric constant of the SiO₂ film 107 is 2.0 to 3.0. This dielectric constant is lower than the dielectric constant 4.0 of a typical nonporous SiO₂ film. Moreover, the typical SiO₂ film 109 is formed on the porous SiO₂ film 107 containing B (boron). Thus, it is possible to prevent moisture from penatrating into the SiO₂ film 107 containing B (boron). Furthermore, the heat resistivity of the SiO₂ films 105, 108, 109 and the porous SiO₂ film 107 containing B (boron) is better than the heat resistivity of an organic insulating film.

Though TEOS (Tetra-Ethyl-Ortho-Silicate) is used as Si-C-O-H compound in the above embodiment, Tri-methoxy-silane (Si(OCH₃)₃H) or the kind may be used. That is, a general formula Si(OR)ₙH₄₋ₙ (R⁼CH₃ or C₂H₅, n⁼1 to 3) may be used as Si-C-O-H compound. This is the same in the following embodiments.

### (b) Second embodiment

The second embodiment is applying the first embodiment to a damascene process.

FIGS. 2A to 2M are cross-sectional views for describing the second embodiment.

First, as shown in FIG. 2A, a BPSG (borophosphosilicate glass) film 202 is formed on a silicon substrate 201. An aluminum layer is formed on the BPSG film 202 and then the aluminum layer is patterned, whereby an aluminum wiring layer 203 is formed. An object to be formed (or a substrate) 204 comprises the silicon substrate 201, the BPSG film 202 and the aluminum wiring layer 203.

Then, as shown in FIG. 2B, an SiO₂ film (the underlying insulating film) 205 having a thickness of 100 nm is formed on the aluminum wiring layer 203. This SiO₂ film 205 is formed by the PECVD method (plasma enhanced chemical vapor deposition). SiH₄ and N₂O are used as the source gas.

Then, as shown in FIG. 2C, an SiO₂ film 206 having a thickness of 500 nm and containing B (boron) is formed on the SiO₂ film (the underlying insulating film) 205. The SiO₂ film 206 containing B (boron) is formed by the CVD method (plasma enhanced chemical vapor deposition) under a pressure of 1 Torr by applying the RF power with a frequency of 13.56 MHz and the RF power with a frequency of 400 kHz with the silicon substrate 201 kept at 100 °C in the atmosphere of TEOS (Tetra-Ethyl-Ortho-Silicate), B₂H₆, O₂ and Ar. C (carbon) and the OH group as well as B are contained in the B-(boron)-containing SiO₂ film 206 formed in this way.

Then, as shown in FIG. 2D, the SiO₂ film 206 containing B (boron) is subjected to the O (oxygen) plasma treatment after a temperature of the silicon substrate 201 is raised to 400 °C. At this time, C (carbon) and the OH group contained in the SiO₂ film 206 containing B (boron) react with the O atom in the O (oxygen) plasma. Thus, C (carbon) and the OH group are changed to CO₂ and H₂O, and then CO₂ and H₂O are released from the film. Then, the voids are created in the portions which have contained C (carbon) and the OH group in the SiO₂ film 206 containing B (boron). Consequently, the SiO₂ film 206 containing B (boron) is changed to a porous SiO₂ film 207 containing B (boron).

Subsequently, as shown in FIG. 2E, the porous SiO₂ film 207 containing B (boron) is subjected to the H (hydrogen) plasma treatment. By this treatment, the dangling bond in the Si-O bond in the film is substituted with the Si-H bond. Thus, the film improves in the moisture absorption resistance.

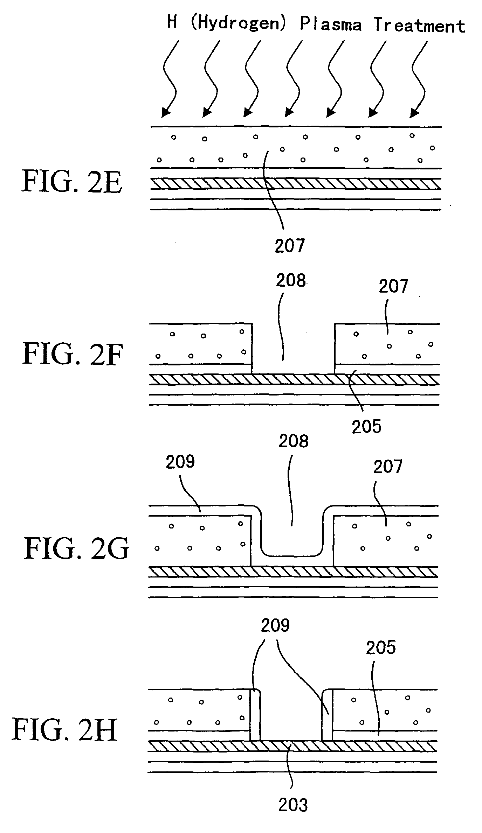

Then, as shown in FIG. 2F, the SiO₂ film (the underlying insulating film) 205 and the porous SiO₂ film 207 containing B (boron) are opened by patterning, whereby a damascene trench 208 is formed. This damascene trench 208 communicates with the aluminum wiring layer 203 formed under the SiO₂ film 205.

Then, as shown in FIG. 2G, an SiO₂ film (a first insulating film) 209 is formed on the porous SiO₂ film 207 containing B (boron) and on sides and on a bottom of the damascene trench 208. This SiO₂ film 209 is formed by the PECVD method (plasma enhanced chemical vapor deposition). The SiO₂ film 209 formed on the sides of the damascene trench 208 can prevent Cu to be later buried in the damascene trench 208 from diffusing into the porous SiO₂ film 207 containing B (boron).

Then, as shown in FIG. 2H, the SiO₂ film (the first insulating film) 209 is anisotropically etched. This result in removing the SiO₂ film 209 other than that on the sides of the damascene trench 208. A contact hole communicating with the aluminum wiring layer 203 is formed in the bottom of the damascene trench 208.

Subsequently, as shown in FIG. 2I, a Cu-plated film 210 is formed in the damascene trench 208 and on the porous SiO₂ film 207 containing B (boron). The Cu-plated film 210 formed in the damascene trench 208 is used as Cu wiring.

Then, as shown in FIG. 2J, the Cu-plated film 210 formed on the porous SiO₂ film 207 containing B (boron) is polished and removed by CMP (Chemical Mechanical Polishing). Thus, the Cu-plated film remains only in the damascene trench 208.

Then, as shown in FIG. 2K, a TiN film 211 for a barrier metal is formed on the damascene trench 208. This TiN film 211 can prevent Cu in the damascene trench 208 from diffusing into the SiO₂ film to be later formed on the damascene trench 208.

Then, as shown in FIG. 2L, the patterning leaves a TiN film 211a formed on the damascene trench 208 and etches away the TiN film 211 formed on the other portions.

Subsequently, as shown in FIG. 2M, an SiO₂ film (the cover insulating film) 212 is formed on the SiO₂ film 207 containing B (boron) and the TiN film 211a. This SiO₂ film 212 is formed by the PECVD method. SiH₄ and N₂O are used as the source gas.

As described above, the interlayer insulating film having the good heat resistivity, the good moisture absorption resistance and the low dielectric constant is formed on the substrate 204. That is, the SiO₂ film 207 containing B (boron) is porous, and thus the dielectric constant of the SiO₂ film 207 is lower than that of a typical B-containing SiO₂ film (a BSG film). Moreover, the typical SiO₂ film (the cover insulating film) 212 is formed on the porous SiO₂ film 207 containing B (boron). Thus, it is possible to prevent the moisture from penetrating into the porous SiO₂ film 207. Furthermore, the heat resistivity of the porous SiO₂ film 207 containing B (boron) is better than the heat resistivity of the organic insulating film.

### (c) Third embodiment

FIGS. 3A to 3L are cross-sectional views for describing the third embodiment. FIG. 4 is a graph showing time dependency of an H₂ flow rate, a TEOS (Tetra-Ethyl-Ortho-Silicate) flow rate, an O₂ flow rate, an Ar flow rate and the plasma in the third embodiment.

First, as shown in FIG. 3A, a BPSG (borophosphosilicate glass) film 302 is formed on a silicon substrate 301. The aluminum layer is formed on the BPSG film 302 and then the aluminum layer is patterned, whereby an aluminum wiring layer 303 is formed. A substrate 304 comprises the silicon substrate 301, the BPSG film 302 and the aluminum wiring layer 303.

Then, as shown in FIG. 3B, an SiO₂ film (the underlying insulating film) 305 is formed on the aluminum wiring layer 303. This SiO₂ film 305 is formed by the PECVD method (plasma enhanced chemical vapor deposition). SiH₄ and N₂O are used as the source gas.

Then, as shown in FIG. 3C, a porous SiO₂ film 306 is formed on the SiO₂ film (the underlying insulating film) 305. This porous SiO₂ film 306 is formed by using the plasma changing with the passage of tine as shown in FIG. 10 in the atmosphere of TEOS (Tetra-Ethyl-Ortho-Silicate), H₂, Ar and O₂ having the flow rate changing with the passage of time as shown in FIG. 10 with the silicon substrate 301 kept at 350 °C. During a time period from T1 to T2 in FIG. 4, the plasma is generated in the atmosphere of TEOS and H₂, so that the process of the PECVD (plasma enhanced chemical vapor deposition) takes place. At this time, the pressure is 1.0 Torr. In the film formed at this time, many C-O-H polymers are contained and a network structure composed of a large number of SiO₂ is formed. During the time period from T2 to T3 in the drawing, the plasma is not generated, so that annealing takes place in the atmosphere of O₂. At this time, the pressure is 0.1 Torr. By this annealing, the C-O-H polymers contained in the film formed during the time period from T1 to T2 are oxidized by O₂, and then the C-O-H polymers are released from the film. Thus, only the network structure of SiO₂ remains in the film, and therefore many voids are created in the film. In order to sufficiently oxidize the C-O-H polymers, it is desirable that the thickness of the film containing the C-O-H polymers is sufficiently reduced by sufficiently reducing an interval between T2 and T1.

The porous SiO₂ film 306 is formed by repeating the PECVD in the atmosphere of TEOS, H₂ and Ar and the annealing in the atmosphere of O₂ as described above.

In this embodiment, the RF power with a frequency of 13.56 MHz and the RF power with a frequency of 400 kHz are used as the RF power for generating the plasma. The respective RF powers are 300 W and 50 W. In FIG. 4, T1 = 5 sec, T2 = 10 sec and T3 = 15 sec.

Then, as shown in FIG. 3D, the porous SiO₂ film 306 is subjected to the H (hydrogen) plasma treatment. By this treatment, the dangling bond in the Si-O bond on the inner surface of the voids is replaced by the Si-H bond. Thus, the film improves in the moisture absorption resistance.

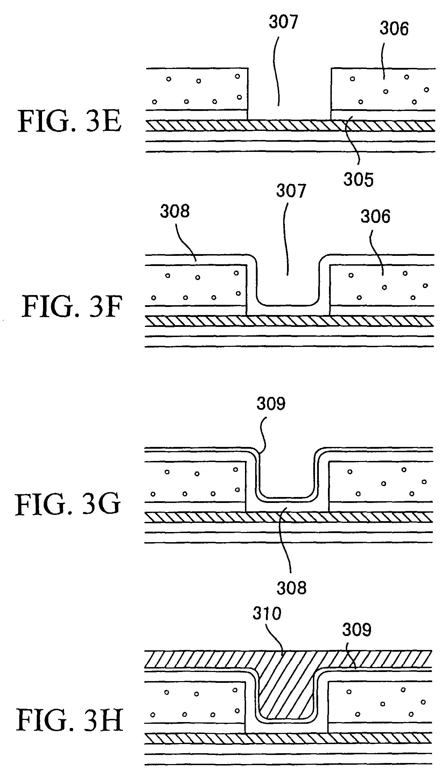

Subsequently, as shown in FIG. 3E, the SiO₂ film (the underlying insulating film) 305 and the porous SiO₂ film 306 are opened by the patterning, whereby a damascene trench 307 is formed. This damascene trench 307 reaches to the aluminum wiring layer 303 formed under the SiO₂ film 305.

Then, as shown in FIG. 3F, a TiN film 308 for the barrier metal is formed on the porous SiO₂ film 306 and on the sides and on the bottom of the damascene trench 307. This TiN film 308 can prevent the Cu-plated film to be later formed in the damascene trench 307 from diffusing around the damascene trench 307.

Then, as shown in FIG. 3G, a Cu seed layer 309 is formed on the TiN film 308. This Cu seed layer 309 is used as a conductive layer for supplying a current to form the Cu-plated film on the Cu seed layer 309.

Then, as shown in FIG. 3H, a Cu-plated film 310 is formed on the Cu seed layer 309, and Cu is buried in the damascene trench 307.

Subsequently, as shown in FIG. 3I, the TiN film 308 formed on the porous SiO₂ film 306, the Cu seed layer 309 and the Cu-plated film 310 are polished and removed by the CMP method (Chemical Mechanical Polishing method). Thus, the Cu-plated film remains only in the damascene trench 307.

Then, as shown in FIG. 3J, an SiN film 311 for preventing Cu from oxidizing is formed on the Cu-plated film 310 polished by the CMP method. Desirably, an anti-oxidizing film such as the SIN film is formed as soon as possible after the polishing by the CMP method, because Cu is prone to be oxidized compared to Al.

Then, as shown in FIG. 3K, a porous SiO₂ film 312 is formed on the SiN film 311. This porous SiO₂ film 312 is formed in the same manner as the porous SiO₂ film 306 previously formed. That is, the porous SiO₂ film 312 is formed by using the plasma changing with the passage of time as shown in FIG. 4 in the atmosphere of TEOS, H₂, Ar and O₂ having the flow rate changing with the passage of time as shown in FIG. 10 with the silicon substrate 301 kept at 350 °C. The RF power with a frequency of 13.56 MHz and the RF power with a frequency of 400 kHz are used as the RF power for use in this case. The respective powers are 300 W and 50 W. In FIG. 4, T1 = 5 sec, T2 = 10 sec and T3 = 15 sec.

Then, as shown in FIG. 3L, the porous SiO₂ film 312 is subjected to the H (hydrogen) plasma treatment. By this treatment, the dangling bond in the Si-O bond on the inner surface of the voids is replaced by the Si-H bond. Thus, the film improves in the moisture absorption resistance.

As described above, the interlayer insulating film having the good heat resistivity, the good moisture absorption resistance and the low dielectric constant is formed on the substrate 304. That is, the SiO₂ films 306 and 312 are porous, and thus the dielectric constant of these films is 2.0 to 3.0. This dielectric constant is lower than the dielectric constant of the typical nonporous SiO₂ film. Moreover, the porous SiO₂ tune 306 and 312 are subjected to the H (hydrogen) plasma treatment. Thus, the film improves in the moisture absorption resistance. Additionally, the heat resistivity of the porous SiO₂ films 306 and 312 is better than the heat resistivity of the organic insulating film.

### (d) Fourth embodiment

The fourth embodiment differs from the third embodiment only in the method for forming the porous SiO₂ film.

FIGS. 3A to 3L are cross-sectional views for describing the fourth embodiment. FIG. 5 is a graph showing the time dependency of the H₂ flow rate, the TEOS (Tetra-Ethyl-Ortho-Silicate) flow rate, the O₂ flow rate, the Ar flow rate and the plasma in the fourth embodiment.

First, as shown in FIG. 3A, the BPSG (borophosphosilicate glass) film 302 is formed on the silicon substrate 301. The aluminum layer is formed on the BPSG film 302 and then the aluminum layer is patterned, whereby the aluminum wiring layer 303 is formed. The substrate 304 comprises the silicon substrate 301, the BPSG film 302 and the aluminum wiring layer 303.

Then, as shown in FIG. 3B, the SiO₂ film 305 (the underlying insulating film) is formed on the aluminum wiring layer 303. This SiO₂ film 305 is formed by the PECVD method (plasma enhanced chemical vapor deposition). SiH₄ and N₂O are used as the source gas.

Then, as shown in FIG. 3C, the porous SiO₂ film 306 is formed on the SiO₂ film (the underlying insulating film) 305. This porous SiO₂ film 306 is formed by using the plasma changing with the passage of time as shown in FIG. 5 in the atmosphere of TEOS, H₂, Ar and O₂ having the flow rate changing with the passage of time as shown in FIG. 5 with the silicon substrate 301 kept at 350 °C.

The fourth embodiment differs from the third embodiment in that the plasma does not change with the passage of time and thus the plasma having a fixed intensity is generated during film formation and in that O₂ is added to the atmosphere of TEOS, H₂ and Ar during the film formation.

During the time period from T1 to T2 in FIG. 5, the process of the plasma CVD (plasma enhanced chemical vapor deposition) takes place in the atmosphere of TEOS, H₂, Ar and O₂. At this time, the pressure is 1.0 Torr. Many C-O-H polymers are contained in the film formed at this time. Because of O₂ added to the atmosphere, a content of SiO₂ in the film is higher than the content of SiO₂ of the third embodiment. Thus, the film improves in stability. Decomposition reaction by OH allows the larger network structure of SiO₂ to be formed.

Moreover, during the time period from T2 to T3 in the drawing, the annealing takes place in a plasma atmosphere of O₂. At this time, the pressure is 0.1 Torr. When the annealing occurs in the plasma atmosphere of O₂ in this manner, outgassing in the film improves compared to the outgassing by the annealing in the atmosphere of O₂ in the third embodiment. By this annealing, the C-O-H polymers contained in the film formed during the time period from T1 to T2 are oxidized by O₂, and then the C-O-H polymers are released from the film. Thus, only the network structure of SiO₂ remains in the film, and therefore many voids are created in the film. A size of the void created at this time is larger than the size of the void of the third embodiment. In order to sufficiently oxidize the C-O-H polymers, it is desirable that the thickness of the film containing the C-O-H polymers is sufficiently reduced by sufficiently reducing the interval between T2 and T1.

The porous SiO₂ film 306 is formed by repeating the plasma CVD in the atmosphere of TEOS, H₂, Ar and O₂ and the annealing in the plasma atmosphere of O₂ as described above.

In this embodiment, the RF power with a frequency of 13.56 MHz and the RF power with a frequency of 400 kHz are used in order to generate the plasma. The respective RF powers are 300 W and 50 W. In FIG. 5, T1 = 5 sec, T2 = 10 sec and T3 = 15 sec.

Then, as shown in FIG. 3D, the porous SiO₂ film 306 is subjected to the H (hydrogen) plasma treatment. By this treatment, the dangling bond in the Si-O bond on the inner surface of the voids is replaced by the Si-H bond. Thus, the film improves in the moisture absorption resistance.

Subsequently, as shown In FIG. 3E, the SiO₂ film 305 (the underlying insulating film) and the porous SiO₂ film 306 are opened by the patterning, whereby the damascene trench 307 is formed. This damascene trench 307 communicates with the aluminum wiring layer 303 formed under the SiO₂ film 305.

Then, as shown in FIG. 3F, the TiN film 308 for the barrier metal is formed on the porous SiO₂ film 306 and on the sides and the bottom of the damascene trench 307. This TiN film 308 can prevent the Cu-plated film to be later formed in the damascene trench 307 from diffusing around the damascene trench 307.

Then, as shown in FIG. 3G, the Cu seed layer 309 is formed on the TiN film 308. This Cu seed layer 309 is used as the conductive layer for supplying the current to form the Cu-plated film on the Cu seed layer 309.

Then, as shown in FIG. 3H, the Cu-plated film 310 iS formed on the Cu seed layer 309, and Cu is embedded in the damascene trench 307.

Subsequently, as shown in FIG. 3I, the TiN film 308 formed on the porous SiO₂ film 306, the Cu seed layer 309 and the Cu-plated film 310 are polished and removed by the CMP method (Chemical Mechanical Polishing method). Thus, the Cu-plated film remains only in the damascene trench 307.

Then, as shown in FIG. 3J, the SiN film 311 for preventing Cu from oxidizing is formed on the Cu-plated film 310 polished by the CMP method. Desirably, the anti-oxidizing film such as the SiN film is formed as soon as possible after the polishing by the CMP method, because Cu is prone to be oxidized compared to Al.

Then, as shown in FIG. 3K, the porous SiO₂ film 312 is formed on the SiN film 311. This porous SiO₂ film 312 is formed in the same manner as the porous SiO₂ film 306 previously formed. That is, the porous SiO₂ film 312 is formed by using the plasma changing with the passage of time as shown in FIG. 5 in the atmosphere of TEOS, H₂, Ar and O₂ having the flow rate changing with the passage of time as shown in FIG. 5 with the silicon substrate 301 kept at 350 °C. The RF power with a frequency of 13.56 MHz and the RF power with a frequency of 400 kHz are used as the RF power for use in this case. The respective RF powers are 300 W and 50 W. In FIG. 5, T1 = 5 sec, T2 = 10 sec and T3 = 15 sec.

Then, as shown in FIG. 3L, the porous SiO₂ film 312 is subjected to the H (hydrogen) plasma treatment. By this treatment, the dangling bond in the Si-O bond on the inner surface of the voids is replaced by the Si-H bond. Thus, the film improves in the moisture absorption resistance.

As described above, the interlayer insulating film having the good heat resistivity, the good moisture absorption resistance and the low dielectric constant is formed on the substrate 304. That is, the size of the void included in the porous SiO₂ films 306 and 312 is larger than the size of the void of the third embodiment. Thus, the dielectric constant of the porous SiO₂ films 306 and 312 is 2.0 to 2.5. This dielectric constant is still lower than the dielectric constant of the third embodiment. Moreover, the porous SiO₂ films 306 and 312 are subjected to the H (hydrogen) plasma treatment. Thus, the film improves in the moisture absorption resistance. Furthermore, the heat resistivity of the porous SiO₂ films 306 and 312 is better than the heat resistivity of the organic insulating film.

Besides, the annealing methods according to though the third and fourth embodiments are applied to the interlayer insulating film not containing B, those may be applied to the interlayer insulating film 106, 206 containing B in the first and second embodiments.

Further, the annealing methods according to the first and second embodiments may be applied to the interlayer insulating film not containing B in the third and fourth embodiments.

### (2) Description of an apparatus for forming the interlayer insulating film according to a fifth embodiment of the present invention

The apparatus for forming the interlayer insulating film according to the fifth embodiment will be described with reference to FIGS. 4, 5 and 6.

FIG. 6 shows a constitution of the apparatus for forming the interlayer insulating film according to the fifth embodiment. In the drawing, numeral 512 denotes a chamber for forming the film. Numeral 510 denotes a gas inlet for introducing the reaction gas into the chamber. Numeral 515 denotes a wafer. Numeral 511 denotes a gas discharging device for uniformly dispersing the source gas onto the wafer 515. Numeral 513 denotes a wafer holder containing a heater. Numeral 514 denotes a gas outlet for exhausting the source gas from the chamber.

Numeral 509 denotes a pipe connected to the gas inlet 510. Branch pipes 517, 518, 519 and 520 are connected to an upstream of the pipe 509. The branch pipe 517 is used to supply Ar (argon). The branch pipe 518 is used to supply H₂ (hydrogen). An ozone generator 506 is connected to the branch pipe 519. Thus, O₂ introduced from the upstream is partly changed to O₃, and thus a mixed gas of O₂ and O₃ is introduced into the pipe 509. A container 507 containing TEOS (Tetra-Ethyl-Ortho-Silicate) is connected to the branch pipe 520. Ar or He containing TEOS is introduced into the pipe 520 by bubbling of Ar or He introduced from the upstream. The pipes 509 and 520 are heated by a heater 527 so that TEOS in the pipe is not liquefied. Numeral 508 denotes the heater for heating TEOS. Additionally, MFC (a flow rate controller) is provided in each of these branch pipes. Control signals 521, 522, 523 and 524 are inputted from control means 501 to the MFCs. The reaction gas is controlled by these control signals so that the reaction gas is supplied at a desired flow rate.

Numeral 516 denotes a high-frequency power generator for applying the RF power with a frequency of 13.56 MHz to the gas discharging device 511. Numeral 530 denotes the high-frequency voltage generator for applying the RF power with a frequency of 400 kHz to the wafer holder 513. Numerals 526 and 529 denote switching means for supplying the RF powers generated by the high-frequency power generators 516 and 530 to the chamber.

Control signals 525 and 528 are inputted from the control means 501 to the switching means 526 and 529, respectively, so that the time of application of the RF power is controlled.

FIGS. 4 and 5 show the flow rate of the reaction gas and the time of application of the RF power which are controlled by the control means 501.

During the time period from T1 to T2 in FIG. 4, MFC 502 (for supplying Ar), MFC 503 (for supplying H₂) and MFC 505 (for supplying TEOS) are opened and MFC 504 (for supplying O₂) is closed by the control signals 521, 522, 523 and 524. Thus, Ar, H₂ and TEOS are introduced into the chamber. At the same time, the switching means 526 and 529 are turned on by the control signals 525 and 528, respectively, whereby the RF power is applied to the chamber 512. Thus, during the time period from T1 to T2, the PECVD (plasma enhanced chemical vapor deposition) takes place in the chamber in the atmosphere of Ar, H₂ and TEOS. During this time period, the wafer is kept at 350 °C by a substrate holder 513 containing the heater.

On the other hand, during the time period from T2 to T3 in FIG. 4, the MFC 502 (for supplying Ar), the MFC 503 (for supplying H₂) and the MFC 505 (for supplying TEOS) are closed and the MFC 504 (for supplying O₂) is opened by the control signals 521, 522, 523 and 524. At the same time, the switching means 526 and 529 are turned off by the control signals 525 and 528, respectively, whereby the chamber 512 comes into a state in which the RF power is not applied to the chamber 512. Thus, O₂ alone is introduced into the chamber, so that the annealing by O₂ occurs in the chamber. During this time period, the wafer is kept at 350 °C by the substrate holder 513 containing the heater. In FIG. 4, T1 = 5 sec, T2 = 10 sec and T3 = 15 sec.

FIG. 5 shows another example of the flow rate of the reaction gas and the time of application of the RF power which are controlled by the control means 501. FIG. 11 differs from FIG. 4 in the flow rate of O₂ and the time of application of the RF power.

During the time period from T1 to T2 in FIG. 5, all of the MFC 502 (for supplying Ar), the MFC 503 (for supplying H₂), the MFC 504 (for supplying O₂) and the MFC 505 (for supplying TEOS) are opened by the control signals 521, 522, 523 and 524. Thus, Ar, H₂, O₃ and TEOS are introduced into the chamber. At the same time, the switching means 526 and 529 are turned on by the control signals 525 and 528, respectively, whereby the RF power is applied to the chamber. Thus, during the time period from T1 to T2, the PECVD (plasma enhanced chemical vapor deposition) takes place in the chamber in the atmosphere of Ar, H₂, O₃ and TEOS. During this time period, the wafer is kept at 350 °C by the substrate holder 513 containing the heater.

On the other hand, during the time period from T2 to T3 in FIG. 5, the MFC 502 (for supplying Ar), the MFC 503 (for supplying H₂) and the MFC 505 (for supplying TEOS) are closed by the control signals 521, 522 and 524. The O₂ flow rate during this time period is increased by the control signal 523, compared the O₂ flow rate during the time period from T1 to T2. Moreover, the RF power remains applied to the chamber differently from the RF power in FIG. 4. Thus, O₂ alone is introduced into the chamber, so that the annealing by O₂ occurs in the atmosphere of O₂ plasma. During this time period, the wafer is kept at 350 °C by the substrate holder 513 with the built-in heater. In FIG. 5, T1 = 5 sec, T2 = 10 sec and T3 = 15 sec.

## Claims

1. A method for forming an interlayer insulating film comprising the steps of:
forming a film (106, 206) containing B (boron), C (carbon) and H₂O on a substrate (104, 204) by plasma enhanced chemical vapor deposition using a source gas containing an Si-C-O-H compound, an oxidative gas and a compound containing B (boron); and
annealing said film (106, 206), releasing C (carbon) and H₂O contained in said film (106, 206) from said film (106, 206), and thereby transforming said film (106, 206) into a porous SiO₂ film (107, 207) containing B (boron).

2. A method according to claim 1, wherein said oxidative gas is any one of O₂, O₃ and H₂O.

3. A method according to claim 1, wherein an inert gas is added to said source gas.

4. A method according to claim 3, wherein said inert gas is Ar.

5. A method according to claim 1, wherein said annealing is performed by O (oxygen) plasma.

6. A method according to claim 1, wherein a temperature of said substrate (104, 204) for said annealing is higher than the temperature for forming said film (106, 206) containing B (boron), C (carbon) and OH.

7. A method according to claim 1, wherein said Si-C-O-H compound is one selected from the group consisting of compounds designated by a general formula Si(OR)ₙH₄₋ₙ (R⁼CH₃ or C₂H₅, n⁼1 to 3).

8. A method according to claim 1, wherein an underlying insulating film (105, 205) is formed on said substrate (104, 204), and said porous SiO₂ film (107, 207) is formed on said underlying insulating film (105, 205).

9. A method according to claim 1, wherein said porous SiO₂ film (107, 207) is formed, and then said porous SiO₂ film (107, 207) is subjected to H (hydrogen) plasma treatment.

10. A method according to claim 1, further comprising the steps of:
forming said interlayer insulating film (207) on said substrate (204) and then forming a damascene trench (208) in said interlayer insulating film (207);
forming a side wall insulating film (209) on sides of said damascene trench (208);
embedding a metal film (210) in said damascene trench (208); and
forming a barrier metal layer (211a) on said metal film (210).

11. A method according to claim 10, wherein said side wall insulating film is formed by the steps of:
forming said damascene trench (208) and then forming a first insulating film (209) on said interlayer insulating film (207), on the sides of said damascene trench (208) and on a bottom of said damascene trench (208); and
anisotropically etching said first insulating film (209) to such an extent that said first insulating film (209) formed on the sides of said damascene trench (208) retains and said first insulating film (209) formed on the bottom of said damascene trench (208) is removed.

12. A method according to claim 1, further comprising the steps of:
forming said interlayer insulating film on said substrate and then forming a damascene trench in said interlayer insulating film;
forming a barrier metal layer on the sides and bottom of said damascene trench;
embedding a metal film in said damascene trench; and
forming an anti-oxidizing film on said metal film.

13. A method according to claim 1, wherein said interlayer insulating film (107, 207) is formed, and then a cover insulating film (108, 212) is formed on said interlayer insulating film (107, 207).

14. [3] A method for forming an interlayer insulating film comprising:
a first step of forming a film (306) containing a C-O-H polymer on a substrate (304) by plasma enhanced chemical vapor deposition using a source gas containing an Si-C-O-H compound and H₂; and
a second step of annealing said film, releasing the C-O-H polymer contained in said film from said film, and thereby forming a porous SiO₂ film (306) on said substrate (304).

15. A method according to claim 14, wherein said first step and said second step are alternately repeated.

16. A method according to claim 14, wherein O₂ is added to said source gas.

17. A method according to claim 14, wherein an inert gas is added to said source gas.

18. A method according to claim 17, wherein said inert gas is Ar.

19. A method according to claim 14, wherein said annealing is performed by O (oxygen) plasma.

20. A method according to claim 14, wherein a temperature of said substrate (304) for said annealing is higher than the temperature for forming said film (306) containing the C-O-H polymer.

21. A method according to claim 14, wherein said Si-C-O-H compound is one selected from the group consisting of compounds designated by a general formula Si(OR)ₙH₄₋ₙ (R⁼CH₃ or C₂H₅, n⁼1 to 3).

22. A method according to claim 14, wherein an underlying insulating film (305) is formed on said substrate (304), and said porous SiO₂ film (306) is formed on said underlying insulating film (305).

23. A method according to claim 14, wherein said porous SiO₂ film (306) is formed, and then said porous SiO₂ film (306) is subjected to H (hydrogen) plasma treatment.

24. A method according to claim 14, further comprising the steps of:
forming said interlayer insulating film on said substrate and then forming a damascene trench in said interlayer insulating film;
forming a side wall insulating film on sides of said damascene trench;
embedding a metal film in said damascene trench; and
forming a barrier metal layer on said metal film.

25. A method according to claim 24, wherein said side wall insulating film is formed by the steps of:
forming said damascene trench and then forming a first insulating film on said interlayer insulating film, on the sides of said damascene trench and on a bottom of said damascene trench; and
anisotropically etching said first insulating film to such an extent that said first insulating film formed on the sides of said damascene trench remains and said first insulating film formed on the bottom of said damascene trench is removed.

26. A method according to claim 14, further comprising the steps of:
forming said interlayer insulating film (306) on said substrate (304) and then forming a damascene trench (307) in said interlayer insulating film (306);
forming a barrier metal layer (308) on the sides and bottom of said damascene trench (307);
embedding a metal film (309, 310) in said damascene trench (307); and
forming an anti-oxidizing film (311) on said metal film (309, 310).

27. A method according to claim 14, wherein said interlayer insulating film is formed, and then a cover insulating film is formed on said interlayer insulating film.

28. An apparatus for forming an interlayer insulating film comprising:
a chamber (512) for forming a film;
pipes (509, 517, 518, 519, 520) for supplying source gases to said chamber (512);
flow rate control means (502, 503, 504, 505) attached to said pipes (517, 518, 519, 520), for controlling a flow rate of said source gas;
high-frequency power generating means (516) for applying a high-frequency power to said chamber (512);
switching means (526) for inputting or shutting off said high-frequency power applied to said chamber (512); and
control means (501) for controlling said flow rate control means (502, 503, 504, 505) and said switching means (526).

29. An apparatus according to claim 28, wherein said control means (501) controls said flow rate control means (502, 503, 504, 505), thereby periodically changing the flow rate of said source gas.

30. An apparatus according to claim 28, wherein said control means (501) controls said switching means (526), thereby periodically changing said high-frequency power applied to said chamber (512).

31. An apparatus according to claim 28, wherein said control means (501) controls said flow rate control means (502, 503, 504, 505) and said switching means (526), thereby changing the flow rate of said source gas and said high-frequency power applied to said chamber (512) in the same cycle and in the same phase.

32. An apparatus according to claim 28, wherein said source gas is one selected from the group consisting of a gas mixture of an Si-C-O-H compound and H₂; a gas mixture of an Si-C-O-H compound, H₂ and O₂; a gas mixture of an Si-C-O-H compound, H₂ and Ar; a gas mixture of an Si-C-O-H compound, H₂ and He; a gas mixture of an Si-C-O-H compound, H₂, O₂ and Ar; a gas mixture of an Si-C-O-H compound, H₂, O₂ and He; a gas mixture of an Si-C-O-H compound and H₂O; a gas mixture of an Si-C-O-H compound, H₂O and Ar; and a gas mixture of an Si-C-O-H compound, H₂O and He.

33. A semiconductor device comprising an interlayer insulating film (107, 207) formed by a method for forming an interlayer insulating film according to claim 1.

34. A semiconductor device comprising an interlayer insulating film (306) formed by a method for forming an interlayer insulating film according to any one of claims 14 and 15.

35. A semiconductor device comprising an interlayer insulating film (107, 207, 306)formed by a semiconductor manufacturing apparatus according to any one of claims 28, 29, 30 and 31.
